# FASCICULE DE BREVET EUROPEEN

(11) **EP 0 688 033 B1**
(45) Date de publication et mention de la délivrance du brevet: **01.09.1999**
(21) Numéro de dépôt: 95108413.6
(22) Date de dépôt: 01.06.1995
(51) Int. Cl.: H01H 36/00, H01H 1/66, H01H 11/06, H05K 3/46

(54) **Microcontacteur magnétique et son procédé de fabrication**
Magnetischer Mikroschalter und sein Herstellungsverfahren
Magnetic microswitch and its manufacturing process

(30) Priorité: 17.06.1994 FR 9407468
(43) Date de publication de la demande: 20.12.1995
(73) Titulaire: ASULAB S.A., CH-2501 Bienne (CH)
(72) Inventeur: Bornand, Etienne, CH-2017 Boudry (CH)
(74) Mandataire: Thérond, Gérard Raymond

(56) Documents cités:
- EP-A- 0 459 665
- EP-A- 0 602 538
- DD-A- 248 454
- FR-A- 2 349 962
- US-A- 3 974 468
- US-A- 4 899 439
- US-A- 4 920 639
- PHYSIKALISCHE BLATTER, vol. 49, no. 3, Mars 1993 WEINHEIM DE, pages 179-184, BLEY ET AL 'Aufbruch in die Mikrowelt'

## Description

La présente invention concerne un microcontacteur magnétique, c'est-à-dire un contacteur électrique ayant des dimensions de l'ordre de quelques dizaines de microns, comportant une poutre flexible maintenue au dessus d'un substrat pourvu d'un plot de contact, ladite poutre étant au moins partiellement réalisée en un matériau ferromagnétique susceptible d'être attiré par un aimant, de façon à ouvrir ou à fermer un contact électrique.

L'invention concerne également un procédé de fabrication qui permet d'obtenir ledit microcontacteur par croissance galvanique des différents matériaux conducteurs qui le composent.

Les dispositifs permettant de fermer ou d'ouvrir un circuit électrique sous l'influence du champ magnétique créé par l'approche d'un aimant sont connus depuis longtemps et, selon une évolution naturelle, les perfectionnements apportés au principe de base ont concerné non seulement leur construction, mais aussi leur miniaturisation.

Au niveau de la construction, on peut citer l'un des dispositifs décrits dans le brevet US 3 974 468, dans lequel une lame flexible conductrice non ferromagnétique est coudée, puis fixée sur un support portant le plot de contact, ladite lame étant, sur sa portion en regard du support, partiellement revêtue d'un matériau ferromagnétique pouvant être attiré par un aimant pour fermer le contact. Les dimensions de la lame peuvent être réduites, sans qu'il soit pour autant possible d'envisager la réalisation d'un assemblage mécanique de pièces ayant des dimensions de l'ordre de quelques dizaines de microns.

Au niveau de la miniaturisation, les techniques de micro-usinage, et en particulier les techniques de gravure des plaquettes de silicium, ont permis d'obtenir des structure de très petites dimensions. Par exemple, le brevet DD 248 454 décrit un contacteur magnétique dont la base et la lame élastique sont conformées par gravure d'une plaquette de silicium, les parties devant être conductrices ou ferromagnétiques étant ensuite appliquées par dépôts galvaniques. Comme on le voit, ce procédé de construction présente l'inconvénient de nécessiter une succession d'étapes faisant appel à des techniques de natures différentes.

Des structures comportant des bandes conductrices superposées de très petites dimensions peuvent également être obtenues par des dépôts galvaniques successifs à travers des masques, essentiellement dans le but de créer des plaques d'interconnexion pour des circuits électroniques. Par exemple, le brevet EP 0 459 665 décrit un dispositif du type précédent, dans lequel les masques sont conservés dans le produit final. Dans le brevet US 4 899 439, il est par contre proposé d'éliminer les masques pour obtenir une structure rigide évidée tridimensionnelle. Toutefois, dans les deux exemples ci-dessus, si on fait abstraction des couches d'accrochage, on observera que tout le processus de croissance galvanique est conduit avec un seul et unique matériau, duquel on attend uniquement des propriétés conductrices, sans que des propriétés ferromagnétiques additionnelles permettent d'envisager une nouvelle application. On observera également que les lames ou les poutres des structures ainsi obtenues sont dépourvues de toute propriété mécanique exploitable, en particulier de toute flexibilité.

Toutefois, contrairement à cet état de la technique qui vient d'être rappelé, en faisant conjointement appel à des matériaux possédant des propriétés de flexibilité et des propriétés ferromagnétiques, la demanderesse a déjà réalisé un microcontacteur du type "reed", ayant des dimensions de l'ordre de quelques dizaines de microns. Un tel microcontacteur "reed" fait l'objet de la demande de brevet EP 0 602 538, incorporée dans la présente demande par référence. Le dispositif qui est décrit est obtenu par croissance galvanique d'un matériau conducteur et d'un matériau ferromagnétique à travers des masques, de façon à obtenir deux poutres ferromagnétiques en regard l'une de l'autre et séparées par un espace, au moins une des poutres étant flexible et reliée au support par un pied. Bien que donnant entière satisfaction, un tel dispositif présente les inconvénients usuels des contacteurs reed, à savoir une utilisation nécessitant un positionnement très précis du générateur de flux magnétique, et une trop grande sensibilité aux perturbations pouvant être induites par la proximité d'autres pièces ferromagnétiques.

La présente invention a donc pour but de procurer un microcontacteur magnétique permettant de remédier à ces inconvénients, en ce que le positionnement d'un aimant pour l'actionner n'exige pas une aussi grande précision, et en ce que son fonctionnement n'est pas influencé par la proximité d'autres pièces ferromagnétiques. Comme on le verra dans la suite de la description, le microcontacteur selon l'invention offre encore l'avantage d'avoir une épaisseur hors tout encore plus faible que celle du dispositif décrit dans le brevet EP 0 602 538, et de pouvoir être produit à un coût inférieur, en raison du plus petit nombre d'étapes nécessaires à sa réalisation.

Un autre but de l'invention est donc de procurer un procédé de fabrication permettant d'obtenir de façon avantageuse un microcontacteur magnétique ayant des dimensions de l'ordre de quelques dizaines de microns, ce que ne permettaient pas les techniques usuelles d'usinage, voire de micro-usinage.

Par commodité, le microcontacteur magnétique selon l'invention sera par la suite seulement désigné par "contacteur MMC".

Ainsi l'invention a pour objet un contacteur MMC comportant une poutre flexible réalisée en un ou plusieurs matériaux conducteurs, dont une extrémité est solidaire d'un substrat par l'intermédiaire d'un pied, et dont la partie distale est située au dessus d'un plot de contact ménagé sur ledit substrat, lesdits pieds et plots étant composés de matériaux conducteurs et une partie au moins de ladite poutre comportant un matériau ferromagnétique susceptible d'être actionné par un aimant, permettant de rapprocher ou à d'éloigner du plot de contact la partie distale de la poutre pour établir ou couper un contact électrique.

La présente invention a également pour but de fournir un procédé de fabrication par croissance galvanique d'un microcontacteur magnétique du type précédent, comprenant la succession des étapes suivantes :
a) création sur un substrat isolant de deux zones conductrices séparées;
b) création d'un premier masque par dépôt d'une couche de photorésist et structuration, de façon à obtenir au moins deux fenêtres situées chacune au dessus d'une zone conductrice, et à proximité de leurs bords en regard;
c) croissance galvanique d'un métal pour créer des plots dans les fenêtres jusqu'à affleurement du métal à la surface du photorésist;
d) création d'un deuxième masque par dépôt d'une couche de photorésist et structuration dans toute son épaisseur d'une fenêtre au-dessus d'un seul plot, ladite fenêtre présentant un faible rapport d'aspect, c'est-à-dire ayant des parois évasées;
e) dépôt d'un niveau de métallisation intermédiaire sur toute la surface du photorésist, des parois et du fond de la fenêtre conformée à l'étape d);
f) création d'un troisième masque par dépôt d'une couche de photorésist épais et structuration dans toute son épaisseur d'une chenal s'étendant entre les bords les plus éloignés des plots situés près des bords en regard des zones conductrices du substrat;
g) croissance galvanique d'un matériau ferromagnétique, pour former la poutre, cette étape étant éventuellement précédée de la croissance galvanique d'une faible épaisseur d'un matériau non magnétique destiné à améliorer le contact;
h) croissance galvanique d'un matériau compressif
i) élimination, en une ou en plusieurs étapes, des couches de photorésist et du niveau de métallisation intermédiaire par voie chimique et mécanique, ou uniquement par voie chimique.

Les masques à travers lesquels on effectue la croissance galvanique sont obtenus par des procédés connus, consistant à configurer une couche de résine photosensible, désignée par le terme général de "photorésist", de façon à ménager des fenêtres aux endroits désirés dans son épaisseur.

Selon les types de photorésist employés, et selon les conditions opératoires mises en oeuvre, il est possible de modifier l'aspect des fenêtres réalisées. De façon générale, en suivant les conditions optimales préconisées par le fabricant de photorésist on obtient des fenêtres avec un rapport d'aspect élevé, c'est-à-dire avec des parois sensiblement verticales. Au contraire, en s'éloignant des prescriptions optimales on obtient des fenêtres avec un faible rapport d'aspect, c'est-à-dire des parois évasées.

Le matériau ferromagnétique utilisé dans l'étape g) pour la croissance galvanique de la poutre est par exemple un alliage fer-nickel 20/80.

Dans l'étape h) le matériau compressif utilisé est par exemple le chrome. De façon équivalent l'étape h) pourrait être supprimée et remplacée par une étape h') qui précéderait l'étape g) et qui consisterait à effectuer un dépôt galvanique d'un métal tensif. Le matériau utilisé par l'amélioration du contact est par exemple de l'or. De même, bien que le pied et les plots puissent être réalisés en un métal quelconque, on utilise de préférence de l'or pour cette étape de croissance galvanique.

Ainsi, en exécutant les étapes a) à g) et i) du procédé qui vient d'être décrit, on obtient un contacteur MMC dans lequel l'extrémité distale de la poutre et le plot de contact sont séparés par un espace libre. Cela correspond à un premier mode de mise en oeuvre permettant d'obtenir un contacteur MMC normalement ouvert en absence de champ magnétique.

Par contre, en exécutant les étapes a) à i) du procédé, on obtient un contacteur MMC dans lequel le fléchissement imposé à la poutre établit un contact entre son extrémité distale et le plot de contact en absence de champ magnétique. Cela correspond à un deuxième mode de mise en oeuvre permettant d'obtenir un contacteur MMC normalement fermé.

Les caractéristiques et avantages de l'invention seront mieux compris à la lecture de la description détaillée qui va suivre, donnée uniquement à titre d'exemple, et faite en référence aux dessins dans lesquels :
- la figure 1 est une vue de côté en coupe d'un contacteur MMC selon un premier mode de réalisation de l'invention,
- la figure 2 est une vue en perspective simplifiée du contacteur MMC selon le premier mode de réalisation, lorsqu'il est actionné par un aimant,
- la figure 3 est une vue de côté en coupe d'un contacteur MMC selon un deuxième mode de réalisation de l'invention,
- la figure 4 est une vue en perspective simplifiée du contacteur MMC selon le deuxième mode de réalisation, lorsqu'il est actionné par un aimant, et
- les figures 5 à 13 sont des vues de côté en coupe des diverses étapes de fabrication d'un contacteur MMC représenté aux figures 1 ou 3.

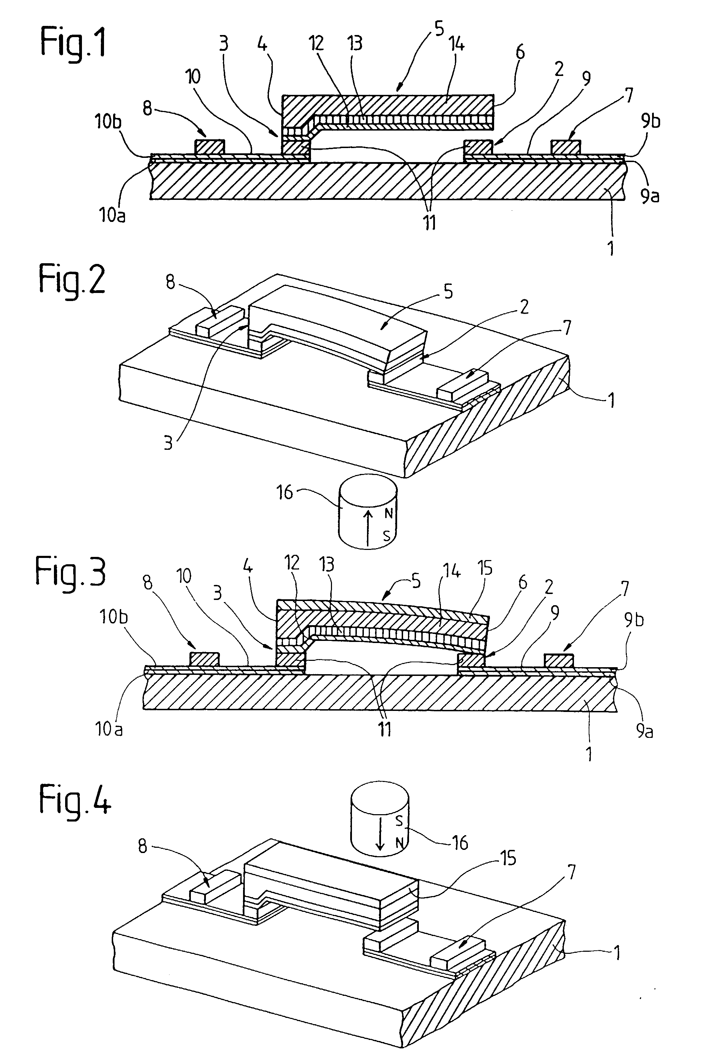

Les figures 1 et 2 représentent un contacteur MMC selon un premier mode de réalisation. Il comporte un substrat isolant 1 supportant un plot de contact 2 et un pied 3, sur la partie supérieure duquel prend appui l'extrémité 4 d'une poutre 5 dont la partie distale 6 est située au-dessus du plot de contact 2, et séparée de celui-ci par un petit espace libre. Le substrat peut en outre comporter deux autres plots 7 et 8 pouvant faciliter le raccordement du contacteur MMC à un circuit électronique. Les plots 7 et 8 sont respectivement reliées au plot 2 et au pied 3 par des zones électriquement conductrices 9 et 10, obtenues par métallisation. Comme on le verra plus loin, chaque couche comporte une première couche 9a (respectivement 10a), destinée à l'accrochage sur le substrat 1, et une deuxième couche 9b (respectivement 10b), destinée à améliorer la croissance des dépôts galvaniques. Le pied et la poutre sont obtenus par croissance galvanique d'un matériau conducteur 11, qui est choisi de préférence pour assurer un contact électrique de bonne qualité. On utilise par exemple de l'or, la hauteur du plot 2 étant typiquement comprise entre 5 et 10µm, et la hauteur allant de la base du pied 2 à la face supérieure de la poutre 5 étant comprise entre 10 et 25µm, de sorte que l'espace séparant l'extrémité distale 6 de la poutre et le plot 2 soit sensiblement comprise entre 2 et 5µm. La poutre est obtenue par croissance galvanique d'un matériau ferromagnétique 14 ayant une faible hystérèse, tel qu'un alliage fer-nickel 20/80, ladite croissance étant éventuellement précédée de la croissance d'une couche plus mince 13, destinée à améliorer le contact, tel qu'une couche d'or. Comme cela apparaît plus clairement sur la figure 2, cette poutre a une section sensiblement rectangulaire d'une épaisseur comprise entre 3 et 10µm, d'une largeur comprise entre 5 et 20µm et d'une longueur comprise entre 300 et 600µm, de sorte qu'elle possède une flexibilité suffisante pour venir en contact avec le plot 2 lorsqu'elle est attirée par un aimant 16.

Selon une technique connue en soi, le contacteur MMC n'est pas produit de façon unitaire, mais par lots ou "batch" sur un même substrat, chaque contacteur pouvant ensuite être découpé. De même, avant l'opération de découpe il est possible, voire souhaitable, de fixer un capot de protection au-dessus de chaque contacteur, par exemple par collage.

Les figures 3 et 4 représentent un deuxième mode de réalisation d'un contacteur MMC selon l'invention. En comparant les figures 1 et 3, on observe que la poutre 5 comporte une couche supplémentaire 15 de dépôt galvanique. Ce dépôt est réalisé avec un matériau conducteur, possédant ou non des propriétés ferromagnétiques, et ayant par dépôt galvanique des propriétés compressives. Dans le cas présent, on a effectué un dépôt galvanique de chrome, d'une épaisseur comprise entre 1 et 5µm. Comme on le voit sur la figure 3, à l'issue du procédé de fabrication qui sera expliqué plus en détail ci-après, le dépôt galvanique de chrome crée une contrainte qui va, en absence de tout champ magnétique, faire fléchir la poutre et maintenir le contact entre le plot 2 et l'extrémité distale 6. La figure 4 représente en perspective le contacteur MMC de la figure 3 en position ouverte lorsqu'on approche un aimant 16.

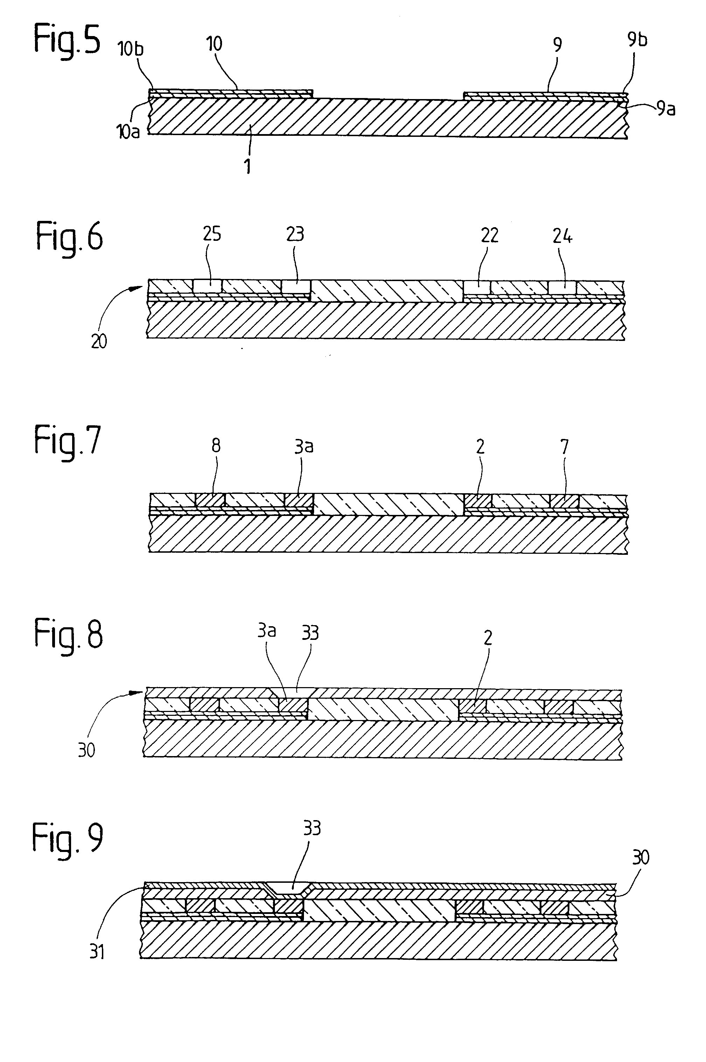

En se référant maintenant aux figures 5 à 13, on va décrire de façon plus détaillée un exemple de réalisation du procédé qui permet d'obtenir un contacteur MMC selon l'invention à partir d'un substrat isolant 1. Ce substrat peut être naturellement isolant, tel que le verre ou la céramique, ou rendu isolant par un traitement préalable.

Ainsi, lorsqu'on utilise une plaquette de silicium en raison des avantages qu'elle présente pour la fabrication en lots ou "batch", on effectue une oxydation préalable dans un four en présence d'oxygène de façon à créer une pellicule isolante quasi monomoléculaire de dioxyde de silicium.

Dans une première étape, représentée à la figure 5, on réalise des zones conductrices isolées 9, 10 en gravant, selon une technique classique, une métallisation effectuée sur le substrat 1 par évaporation thermique d'un métal d'accrochage, puis d'un métal destiné à améliorer l'efficacité du dépôt galvanique. La première couche 9a, 10a est par exemple constituée par 50 nm de titane et la deuxième par 200 nm d'or.

Dans la deuxième étape, illustrée par la figure 6, on dépose sur toute la surface des zones conductrices 9, 10 et du substrat 1 qui les sépare, une première couche de photorésist 20, sur une épaisseur comprise entre 5 à 10µm. Cette couche est ensuite structurée selon les techniques habituelles pour obtenir deux fenêtres 22, 23 au-dessus des zones conductrices 9, 10, et à proximité de leurs bords en regard, ainsi que deux autres fenêtres 24, 25 au-dessus des zones conductrices, et dans l'alignement des deux premières fenêtres. En suivant les recommandations d'emploi formulées par le fabricant de photorésist, on obtient des fenêtres présentant un fort rapport d'aspect, c'est-à-dire ayant des parois sensiblement verticales.

Dans l'étape suivante représentée à la figure 7, on fait croître dans les fenêtres 22, 23, 24, 25, un dépôt galvanique d'un métal, jusqu'à affleurement à la surface de photorésist. Pour effectuer cette croissance galvanique, on utilise de préférence un métal peu sensible à la corrosion et susceptible d'assurer un bon contact électrique, tel que l'or. On obtient ainsi quatre plots, le plot 3a constituant la base du pied 3, le plot 2 étant le plot de contact du contacteur MMC et les plots 7, 8 étant les plots de connexion à un circuit électronique extérieur.

Dans la quatrième étape, illustrée par la figure 8, on crée un deuxième masque par dépôt d'une nouvelle couche de photorésist 30 et on effectue une structuration dans toute son épaisseur pour obtenir une seule fenêtre 33 au-dessus du plot 3a. Contrairement à l'étape précédente, en s'éloignant des conditions optimales préconisées pour le photorésist utilisé, on obtient la fenêtre 33 avec un faible rapport d'aspect, c'est-à-dire avec des parois évasées. L'épaisseur de la couche de photorésist déposée dans cette étape sert également à créer un espace d'isolation, compris entre 2 et 5µm, entre le plot de contact 2 et l'extrémité distale 6 de la poutre 5 qui sera obtenue dans les étapes suivantes.

La cinquième étape, telle que représentée à la figure 9, consiste à déposer par évaporation thermique une mince couche de métal sur toute la surface du photorésist 30 et sur les parois et sur le fond de la fenêtre 33. Le métal utilisé est de préférence de l'or, et ce niveau de métallisation intermédiaire est utilisé comme conducteur pour les étapes suivantes de croissance galvanique.

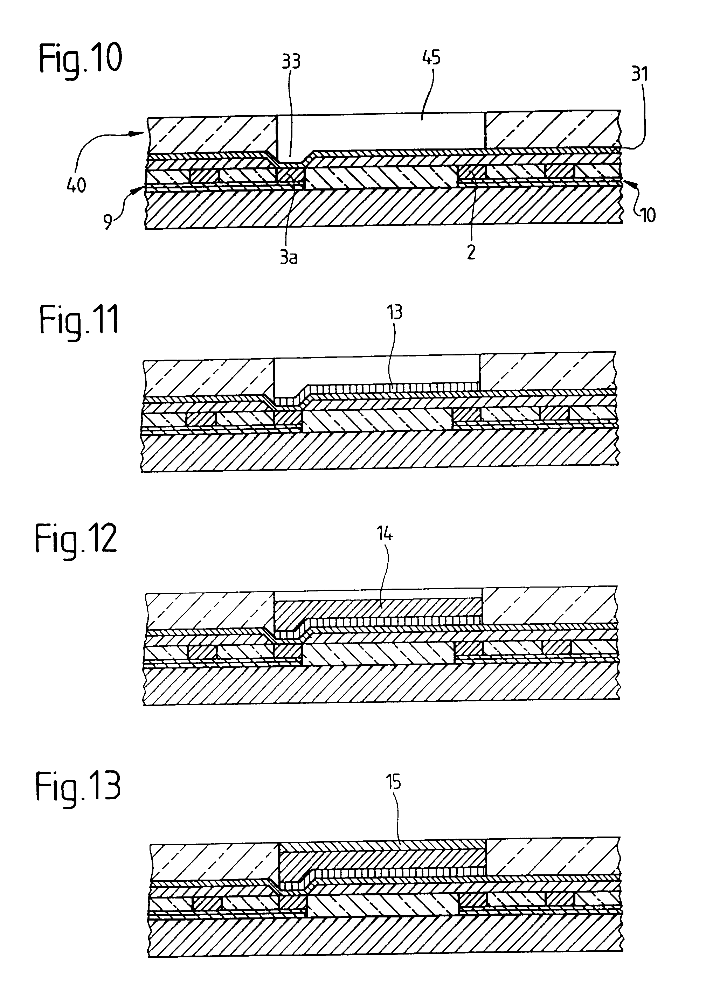

Dans la sixième étape, illustrée par la figure 10, on crée un troisième masque de photorésist épais 40 et on effectue une structuration dans toute son épaisseur de façon à obtenir un chenal 45 s'étendant entre les bords les plus éloignés des plots 2, 3a situés sur les bords en regard des zones conductrices 9, 10. Cette structuration ne laisse donc apparente que la portion de métallisation 31 qui se trouvera située sous la poutre 5 et dans la fenêtre 33 qui servira à la construction de la deuxième partie du pied 3.

Les figures 11 et 12 représentent les étapes de croissance de la poutre 5, consistant en un premier dépôt galvanique 13 assez faible d'or pour améliorer le contact électrique, puis en un dépôt d'une épaisseur comprise entre 3 et 10mµ d'un matériau ferromagnétique qui constitue la matière active de la poutre 5. Le matériau ferromagnétique utilisé dans cet exemple est un alliage fer-nickel 20/80.

Arrivé à ce stade du procédé, les masques 20, 30, 40 qui ont servi à diriger la croissance galvanique et le niveau de métallisation intermédiaire 31 sont éliminés en une seule opération ou par étapes, pour obtenir un contacteur MMC tel que celui représenté à la figure 1. Lorsqu'on effectue cette élimination en une étape, on utilise simultanément un agent chimique qui dissout le photorésist, tel qu'un produit à base d'acétone, et un moyen mécanique qui brise la très mince pellicule de métallisation intermédiaire, tels que des ultrasons. Lorsqu'on effectue cette élimination en plusieurs étapes, on utilise successivement des agents chimiques capables de dissoudre respectivement le photorésist et la métallisation intermédiaire.

Pour obtenir un contacteur MMC, tel que celui représenté à la figure 3, on effectue une étape supplémentaire de croissance galvanique 15, telle que représenté à la figure 13, en utilisant un métal ayant des propriétés compressives, tel que le chrome lorsqu'il est déposé par un procédé galvanique. Après élimination des masques et de la métallisation intermédiaire comme précédemment indiqué, la poutre 5 subit un fléchissement qui la met en contact avec le plot 2.

Le procédé qui vient d'être décrit est susceptible de nombreuses modifications à la portée de l'homme de l'art, tant en ce qui concerne le choix des matériaux, que les dimensions souhaitées pour le contacteur MMC, dans des gammes se situant dans les dizaines de microns.

## Revendications

1. Procédé de fabrication d'un microcontacteur magnétique comportant une poutre flexible (5) en un ou plusieurs matériaux conducteurs (13, 14, 15), ayant une extrémité (4) solidaire d'un substrat isolant (1) par l'intermédiaire d'un pied (3), et une extrémité distale (6) libre positionnée au-dessus d'un plot de contact (2) ménagé sur ledit substrat (1), lesdits pieds (3) et plot (2) étant composés de matériaux conducteurs et pourvus de moyens de connexion (7, 8, 9, 10) à un circuit électronique extérieur, et ladite poutre (5) étant au moins en partie composée d'un matériau ferromagnétique susceptible d'être actionné par un aimant (16) permettant de rapprocher du plot de contact (2) l'extrémité distale (6) pour établir un contact électrique, caractérisé en ce qu'il comprend la succession des étapes suivantes.
a) création sur le substrat (1) de deux zones conductrices séparées (9, 10) comportant chacune une couche de métallisation d'accrochage (9a, 10a) et une couche en un métal non oxydable (9b, 10b).
b) création d'un premier masque par dépôt d'une couche de photorésist (20) et structuration de façon à obtenir au moins deux fenêtres (22, 23) situées au-dessus d'une zone conductrice (9, 10) à proximité de leurs bords en regard, lesdites fenêtres ayant des parois sensiblement verticales.
c) croissance galvanique à l'intérieur des fenêtres d'un matériau conducteur pour obtenir des plots (2, 3a, 7, 8) jusqu'à affleurement dudit matériau à la surface du photorésist.
d) création d'un deuxième masque par dépôt d'une couche de photorésist (30) et structuration dans toute son épaisseur d'une fenêtre au-dessus d'un seul plot (3a), ladite fenêtre ayant des parois évasées.
e) dépôt d'un niveau de métallisation intermédiaire (31) sur toute la surface du photorésist, des parois et du fond de la fenêtre conformée à l'étape d).
f) création d'un troisième masque par dépôt d'une couche de photorésist épais (40), et structuration dans toute son épaisseur d'un chenal (45) s'étendant entre les bords les plus éloignés des plots (2, 3a) situés sur les bords en regard des zones conductrices (9, 10).
g) croissance galvanique d'un matériau ferromagnétique (14), éventuellement précédée de la croissance galvanique d'une faible épaisseur d'un matériau non magnétique (13) destiné à améliorer le contact.
i) élimination, en une ou plusieurs étapes, des couches de photorésist et du niveau de métallisation intermédiaire, par voie chimique et mécanique ou uniquement par voie chimique.

2. Procédé de fabrication d'un microcontacteur magnétique comportant une poutre flexible (5) en un ou plusieurs matériaux conducteurs (13, 14, 15), ayant une extrémité (4) solidaire d'un substrat isolant (1) par l'intermédiaire d'un pied (3), et une extrémité distale (6) libre positionnée en appui sur un plot de contact (2) ménagé sur ledit substrat (1), lesdits pieds (3) et plot (2) étant composés de matériaux conducteurs et pourvus de moyens de connexion (7, 8, 9, 10) à un circuit électronique extérieur, et ladite poutre (5) étant au moins en partie composée d'un matériau ferromagnétique susceptible d'être actionné par un aimant (16) permettant d'éloigner du plot de contact (2) l'extrémité distale (6) pour couper un contact électrique, caractérisé en ce qu'il comprend la succession des étapes suivantes.
a) création sur le substrat (1) de deux zones conductrices séparées (9, 10) comportant chacune une couche de métallisation d'accrochage (9a, 10a) et une couche en un métal non oxydable (9b, 10b).
b) création d'un premier masque par dépôt d'une couche de photorésist (20) et structuration de façon à obtenir au moins deux fenêtres (22, 23) situées au-dessus d'une zone conductrice (9, 10) à proximité de leurs bords en regard, lesdites fenêtres ayant des parois sensiblement verticales.
c) croissance galvanique à l'intérieur des fenêtres d'un matériau conducteur pour obtenir des plots (2, 3a, 7, 8) jusqu'à affleurement dudit matériau à la surface du photorésist.
d) création d'un deuxième masque par dépôt d'une couche de photorésist (30) et structuration dans toute son épaisseur d'une fenêtre au-dessus d'un seul plot (3a), ladite fenêtre ayant des parois évasées.
e) dépôt d'un niveau de métallisation intermédiaire (31) sur toute la surface du photorésist, des parois et du fond de la fenêtre conformée à l'étape d).
f) création d'un troisième masque par dépôt d'une couche de photorésist épais (40), et structuration dans toute son épaisseur d'un chenal (45) s'étendant entre les bords les plus éloignés des plots (2, 3a) situés sur les bords en regard des zones conductrices (9, 10).
g) croissance galvanique d'un matériau ferromagnétique (14), éventuellement précédée de la croissance galvanique d'une faible épaisseur d'un matériau non magnétique (13) destiné à améliorer le contact.
h) croissance galvanique d'un matériau compressif (15).
i) élimination, en une ou plusieurs étapes, des couches de photorésist et du niveau de métallisation intermédiaire, par voie chimique et mécanique ou uniquement par voie chimique.

3. Procédé de fabrication d'un microcontacteur magnétique selon la revendication 1 ou 2, caractérisé en ce que le matériau ferromagnétique (14) est un alliage fer-nickel 20/80.

4. Procédé de fabrication d'un microcontacteur magnétique selon la revendication 1 ou 2, caractérisé en ce que le matériau (13) susceptible d'améliorer le contact est de l'or.

5. Procédé de fabrication d'un microcontacteur magnétique selon la revendication 2, caractérisé en ce que le matériau compressif (15) est du chrome.

## Patentansprüche

1. Verfahren zum Herstellen eines magnetischen Mikroschalters, der einen flexiblen Träger (5) aus einem oder mehreren Leitermaterialien (13, 14, 15) enthält, wovon ein Ende über einen Fuß (3) mit einem isolierenden Substrat (1) fest verbunden ist und ein freies entferntes Ende (6) über einem Kontaktstück (2), das im Substrat (1) ausgebildet ist, positioniert ist, wobei die Füße (3) und das Kontaktstück (2) aus Leitermaterialien aufgebaut und mit Mitteln (7, 8, 9, 10) für den Anschluß an eine externe elektronischen Schaltung versehen sind und der Träger (5) wenigstens zum Teil aus einem ferromagnetischen Material aufgebaut ist, das durch einen Magneten (16) betätigt werden kann, wodurch ermöglicht wird, daß sich das ferne Ende (6) an das Kontaktstück (2) annähert, um einen elektrischen Kontakt herzustellen, dadurch gekennzeichnet, daß es die Abfolge der folgenden Schritte enthält:
(a) Erzeugen zweier getrennter leitender Zonen (9, 10) im Substrat (1), wovon jede eine Haft-Metallisierungsschicht (9a, 10a) und eine Schicht aus einem nichtoxidierbaren Metall (9b, 10b) enthält,
(b) Erzeugen einer ersten Maske durch Ablagern einer Photoresistschicht (20) und einer Strukturierung in der Weise, daß wenigstens zwei Fenster (22, 23) erhalten werden, die sich über einer Leiterzone (9, 10) in der Nähe ihrer gegenüberliegenden Ränder befinden, wobei die Fenster im wesentlichen vertikale Wände besitzen,
(c) galvanisches Wachstum eines Leitermaterials in den Fenstern, um Kontaktstücke (2, 3a, 7, 8) zu erhalten, bis sie mit dem Material auf der Oberfläche des Photoresists bündig sind,
(d) Erzeugen einer zweiten Maske durch Ablagern einer Photoresistschicht (30) und einer Strukturierung in der gesamten Dicke eines Fensters über einem einzigen Kontaktstück (3a), wobei das Fenster konisch erweiterte Wände besitzt,
(e) Ablagern eines Zwischenmetallisierungsniveaus (31) auf der gesamten Oberfläche des Photoresists, den Wänden und dem Boden des Fensters gemäß dem Schritt (d),
(f) Erzeugen einer dritten Maske durch Ablagern einer dicken Photoresistschicht (40) und einer Strukturierung in der gesamten Dicke einer Rinne (45), die sich zwischen den Rändern der am weitesten entfernten Kontaktstücke (2, 3), die sich an den Rändern gegenüber den leitenden Zonen (9, 10) befinden, erstreckt,
(g) galvanisches Wachstum eines ferromagnetischen Materials (14), dem eventuell das galvanische Wachstum eines nichtmagnetischen Materials (13) mit geringer Dicke, das dazu vorgesehen ist, den Kontakt zu verbessern, vorhergeht,
(i) Beseitigen der Photoresistschichten und des Zwischenmetallisierungsniveaus in einem oder mehreren Schritten auf chemischem und mechanischem oder nur auf chemischem Weg.

2. Verfahren zum Herstellen eines magnetischen Mikroschalters, der einen flexiblen Träger (5) aus einem oder mehreren Leitermaterialien (13, 14, 15) enthält, wovon ein Ende über einen Fuß (3) mit einem isolierenden Substrat (1) fest verbunden ist und ein freies entferntes Ende (6) über einem Kontaktstück (2), das im Substrat (1) ausgebildet ist, positioniert ist, wobei die Füße (3) und das Kontaktstück (2) aus Leitermaterialien aufgebaut sind und mit Mitteln (7, 8, 9, 10) für den Anschluß an eine externe elektronische Schaltung versehen sind und wobei der Träger (5) wenigstens zum Teil aus einem ferromagnetischen Material aufgebaut ist, das durch einen Magneten (16) betätigt werden kann, wodurch ermöglicht wird, daß sich das ferne Ende (6) von dem Kontaktstück (2) entfernt, um einen elektrischen Kontakt zu unterbrechen, dadurch gekennzeichnet, daß es die Abfolge der folgenden Schritte enthält:
(a) Erzeugen zweier getrennter leitender Zonen (9, 10) im Substrat (1), wovon jede eine Haft-Metallisierungsschicht (9a, 10a) und eine Schicht aus einem nichtoxidierbaren Metall (9b, 10b) enthält,
(b) Erzeugen einer ersten Maske durch Ablagern einer Photoresistschicht (20) und einer Strukturierung in der Weise, daß wenigstens zwei Fenster (22, 23) erhalten werden, die sich über einer Leiterzone (9, 10) in der Nähe ihrer gegenüberliegenden Ränder befinden, wobei die Fenster im wesentlichen vertikale Wände besitzen,
(c) galvanisches Wachstum eines Leitermaterials in den Fenstern, um Kontaktstücke (2, 3a, 7, 8) zu erhalten, bis sie mit dem Material auf der Oberfläche des Photoresists bündig sind,
(d) Erzeugen einer zweiten Maske durch Ablagern einer Photoresistschicht (30) und einer Strukturierung in der gesamten Dicke eines Fensters über einem einzigen Kontaktstück (3a), wobei das Fenster konisch erweiterte Wände besitzt,
(e) Ablagern eines Zwischenmetallisierungsniveaus (31) auf der gesamten Oberfläche des Photoresists, den Wänden und dem Boden des Fensters gemäß dem Schritt (d),
(f) Erzeugen einer dritten Maske durch Niederschlag einer dicken Photoresistschicht (40) und einer Strukturierung in der gesamten Dicke einer Rinne (45), die sich zwischen den Rändern der am weitesten entfernten Kontaktstücke (2, 3), die sich an den Rändern gegenüber den leitenden Zonen (9, 10) befinden, erstreckt,
(g) galvanisches Wachstum eines ferromagnetischen Materials (14), dem eventuell das galvanische Wachstum eines nichtmagnetischen Materials (13) mit geringer Dicke, das dazu vorgesehen ist, den Kontakt zu verbessern, vorhergeht,
(h) galvanisches Wachstum eines Kompressionsmaterials (15),
(i) Beseitigen der Photoresistschichten und des Zwischenmetallisierungsniveaus in einem oder mehreren Schritten auf chemischem und mechanischem oder nur auf chemischem Weg.

3. Verfahren zum Herstellen eines magnetischen Mikroschalters nach Anspruch 1 oder 2, dadurch gekennzeichnet, daß das ferromagnetische Material (14) eine Eisen-Nickel-Legierung 20/80 ist.

4. Verfahren zum Herstellen eines magnetischen Mikroschalters nach Anspruch 1 oder 2, dadurch gekennzeichnet, daß das Material (13), das den Kontakt verbessern kann, Gold ist.

5. Verfahren zur Herstellung eines magnetischen Mikroschalters nach Anspruch 2, dadurch gekennzeichnet, daß das Kompressionsmaterial (15) Chrom ist.

## Claims

1. Method of manufacturing a magnetic microcontactor comprising a flexible beam (5) in one or more conducting materials (13, 14, 15), having one end (4) attached to an insulating substrate (1) via the intermediary of a foot (3), and a free distal end (6) disposed above a contact stud (2) arranged on said substrate (1), said feet (3) and stud (2) being composed of conducting materials and provided with connecting means (7, 8, 9, 10) to an external electronic circuit, and said beam (5) being at least partly composed of a ferromagnetic material capable of being activated by a magnet (16) enabling distal end (6) to move towards from the contact stud (2) to establish an electrical contact, characterized in that it includes the successive steps of :
a) forming two separate conducting areas (9, 10) each comprising a gripping metallization layer (9a, 10a) and a layer of a non oxydisable metal (9b, 10b) on the substrate (1).
b) forming a first mask by depositing a layer of photoresist (20) and configuring the latter, so as to form at least two windows (22, 23) disposed above a conducting area (9, 10) in the vicinity of their facing edges, said windows having substantially vertical walls.
c) growing by electrodeposition, inside the windows, a conducting material in order to obtain studs (2, 3a, 7, 8) until said material is flush with the photoresist surface.
d) forming a second mask by depositing a layer of photoresist (30) and configuring, over its entire thickness, a window above a single stud (3a), said window having tapered walls.
e) depositing an intermediate metallization layer (31) over the whole surface of the photoresist, walls and the bottom of the window formed in step d).
f) forming a third mask by depositing a thick layer of photoresist (40) and configuring, over its entire thickness, a channel (45) extending between the farthest edges of the studs (2, 3a) disposed on the edges facing the conducting areas (9, 10).
g) growing by electrodeposition a ferromagnetic material (14), to form the beam, this step being possibly preceded by the electrodeposition of a small thickness of a non magnetic material (13) intended to improve the contact.
i) removing, in one or more steps, the photoresist layers and the intermediate metallization layer either chemically and mechanically, or solely chemically.

2. Method of manufacturing a magnetic microcontactor comprising a flexible beam (5) in one or more conducting materials (13, 14, 15), having one end (4) attached to an insulating substrate (1) via the intermediary of a foot (3), and a free distal end (6) disposed above a contact stud (2) arranged on said substrate (1), said feet (3) and stud (2) being composed of conducting materials and provided with connecting means (7, 8, 9, 10) to an external electronic circuit, and said beam (5) being at least partly composed of a ferromagnetic material capable of being activated by a magnet (16) enabling distal end (6) to move away from the contact stud (2) to break an electrical contact, characterized in that it includes the successive steps of :
a) forming two separate conducting areas (9, 10) each comprising a gripping metallization layer (9a, 10a) and a layer of a non oxydisable metal (9b, 10b) on the substrate (1).
b) forming a first mask by depositing a layer of photoresist (20) and configuring the latter, so as to form at least two windows (22, 23) disposed above a conducting area (9, 10) in the vicinity of their facing edges, said windows having substantially vertical walls.
c) growing by electrodeposition, inside the windows, a conducting material in order to obtain studs (2, 3a, 7, 8) until said material is flush with the photoresist surface.
d) forming a second mask by depositing a layer of photoresist (30) and configuring, over its entire thickness, a window above a single stud (3a), said window having tapered walls.
e) depositing an intermediate metallization layer (31) over the whole surface of the photoresist, walls and the bottom of the window formed in step d).
f) forming a third mask by depositing a thick layer of photoresist (40) and configuring, over its entire thickness, a channel (45) extending between the farthest edges of the studs (2, 3a) disposed on the edges facing the conducting areas (9, 10).
g) growing by electrodeposition a ferromagnetic material (14), to form the beam, this step being possibly preceded by the electrodeposition of a small thickness of a non magnetic material (13) intended to improve the contact.
h) growing by electrodeposition a compressive material (15).
i) removing, in one or more steps, the photoresist layers and the intermediate metallization layer either chemically and mechanically, or solely chemically.

3. Method of manufacturing a magnetic microcontactor according to claim 1 or 2, characterized in that the ferromagnetic material (14) is a iron-nickel alloy in a proportion of 20/80 respectively.

4. Method of making a magnetic microcontactor according to claim 1 or 2, characterized in that the material (13) capable of improving the contact is gold.

5. Method of making a magnetic microcontactor according to claim 2, characterized in that the compressive material (15) is chromium.
